# EUROPEAN PATENT APPLICATION

(11) **EP 4 207 248 A1**
(43) Date of publication of application: **05.07.2023**
(21) Application number: 22215934.5
(22) Date of filing: 22.12.2022
(51) Int. Cl.: H01L 21/02

(54) **A NOVEL METHOD OF ANNEALING OUT SILICON DEFECTIVITY**

(30) Priority: 31.12.2021 US 202117566942
(71) Applicant: Texas Instruments Incorporated, Dallas, TX 75265 (US)
(72) Inventor: Ali, Abbas, Plano (US); Whitesell, Christopher Scott, Garland (US); Mahalingam, Pushpa, Richardson (US); Aghoram, Uma, Richardson (US); Pylant, Eddie Dee, Plano (US)
(74) Representative: Zeller, Andreas

(57) **Abstract**

A method of forming an integrated circuit that includes placing a semiconductor substrate in a process chamber at an initial temperature, wherein one or more trenches are located within the semiconductor substrate. The temperature of the substrate is increased in a substantially oxygen-free ambient to an oxide-growth temperature. The temperature is then maintained at the oxide growth temperature while providing an oxidizing ambient, thereby forming an oxide layer on sidewalls of the trench. The temperature of the semiconductor wafer is then reduced to a final temperature below the initial temperature and removed from the process chamber.

## Description

### TECHNICAL FIELD

This disclosure relates to the field of semiconductor devices, and more particularly, but not exclusively, to structures and methods with reduced defectivity due to crystalline defects.

### BACKGROUND

Deep trenches may be formed in a semiconductor substrate for various devices. For example, a deep trench may be filled with an insulator, or lined with an insulator and filled with a conductive material, to serve to isolate an electronic device from other structures or devices on the same substrate. In other examples a deep trench may be filled with a conductive material to serve as a portion of a capacitor terminal.

### SUMMARY

The inventors disclose various methods and devices that may be beneficially applied to electronic devices that employ deep trenches in a semiconductor substrate to realize, e.g. a capacitor or an isolation structure. Disclosed methods and/or structures may beneficially reduce crystalline defects such as, e.g. dislocations, that may result in reduced performance and/or yield loss of electronic devices. While such embodiments may be expected to provide improvements in performance and/or device yield, no particular result is a requirement of the present disclosure unless explicitly recited in a particular claim.

One example provides a method of forming an integrated circuit that includes placing a semiconductor substrate in a process chamber at an initial temperature, wherein the semiconductor substrate contains one or more trenches. The temperature of the substrate is increased in a substantially oxygen-free ambient to an oxide-growth temperature. The temperature is then maintained at the oxide growth temperature while providing an oxidizing ambient, thereby forming an oxide layer on sidewalls of the trench. The temperature of the semiconductor wafer is then reduced to a final temperature below the initial temperature and removed from the process chamber.

Another example provides a method of forming an integrated circuit that includes forming a trench in a semiconductor substrate and then placing the semiconductor substrate in a furnace at a load temperature. The temperature is increased to an oxide growth temperature while flowing an oxygen-free gas through the furnace. After reaching the oxide growth temperature a gas mixture containing oxygen is flowed through the furnace while maintaining the temperature of the semiconductor substrate at the oxide growth temperature. The substrate is then removed from the process chamber at an unload temperature lower than the load temperature.

### BRIEF DESCRIPTION OF THE DRAWINGS

For a detailed description of various examples, reference will now be made to the accompanying drawings in which:
FIGs. 1A-1C present sectional views of an example semiconductor device formed according to a baseline method of formation;
FIG. 2 presents a first temperature profile of a semiconductor substrate formed according to a baseline method of oxide formation, and a second temperature profile of a semiconductor substrate formed according to a method of the disclosure;
FIG. 3 shows a micrograph of a semiconductor substrate formed according to a baseline method, including multiple decorated dislocations at the substrate surface;
FIG. 4 illustrates the spread of values of an example electrical parameter for a baseline process and a process of the disclosure, for each of three values of trench sidewall implant doping;
FIGs. 5A-5C present sectional views of an example semiconductor device formed according to a method of the disclosure; and
FIG. 6 presents a method of the disclosure for forming an integrated circuit.

### DETAILED DESCRIPTION

The present disclosure is described with reference to the attached figures. The figures are not necessarily drawn to scale, and they are provided without implied limitation to illustrate various described examples. Several aspects of the disclosure are described below with reference to example applications for illustration. It should be understood that numerous specific details, relationships, and methods are set forth to provide an understanding of the disclosure. The present disclosure is not limited by the illustrated ordering of acts or events, as some acts may occur in different orders and/or concurrently with other acts or events. Furthermore, not all illustrated acts or events are required to implement a methodology in accordance with the present disclosure.

Toward the goal of reducing defects that may reduce performance and/or yield of some electronic devices, the present disclosure provides, *inter alia*, improved methods of annealing semiconductor substrates with trenches, e.g. deep trenches. In some baseline processes, stress induced by annealing such substrates results in the formation of dislocations in the crystalline structure of the substrate. These dislocations can result in electrical failures of electronic devices formed on the substrate, e.g. due to current leakage. Such failures may result in yield loss and associated costs to the manufacturer. Methods described herein have been found to substantially reduce the number of such defects, resulting in improved manufacturing yield of electronic devices that include deep trenches.

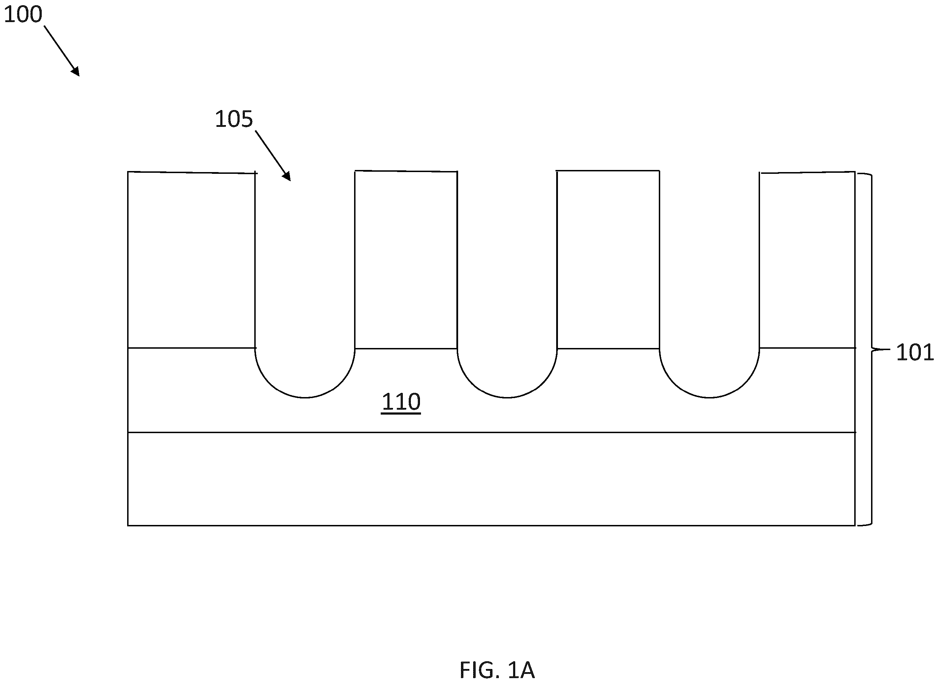

FIGs. 1A-1C show sections of a semiconductor device 100 at various stages of a fabrication sequence with respect to a substrate 101, sometimes referred to as a process flow. The substrate may be n-type or p-type, and in some examples is a lightly doped p-type substrate. The substrate 101 may include an epitaxial layer (not shown) that may have a same or different conductivity type as an underlying handle wafer. Without implied limitation the current discussion may refer to the substrate 101 and such optional epitaxial layer as having a first conductivity type, e.g. p-type.

FIG. 1A shows the device 100 after formation of trenches 105 in the substrate 101. Some processing prior to Fig. 1A has produced the trenches 105 in the substrate 101. The trenches are not limited to having any particular depth, but may have a depth of 1 µm or more. Such trenches may be referred to colloquially as "deep trenches", and may serve various purposes, among them being to provide a path from the top surface of the substrate 101 to a buried layer 110 having a second conductivity type, e.g. n-type. The trenches 105 and the buried layer may be formed by any known or future-developed process flow.

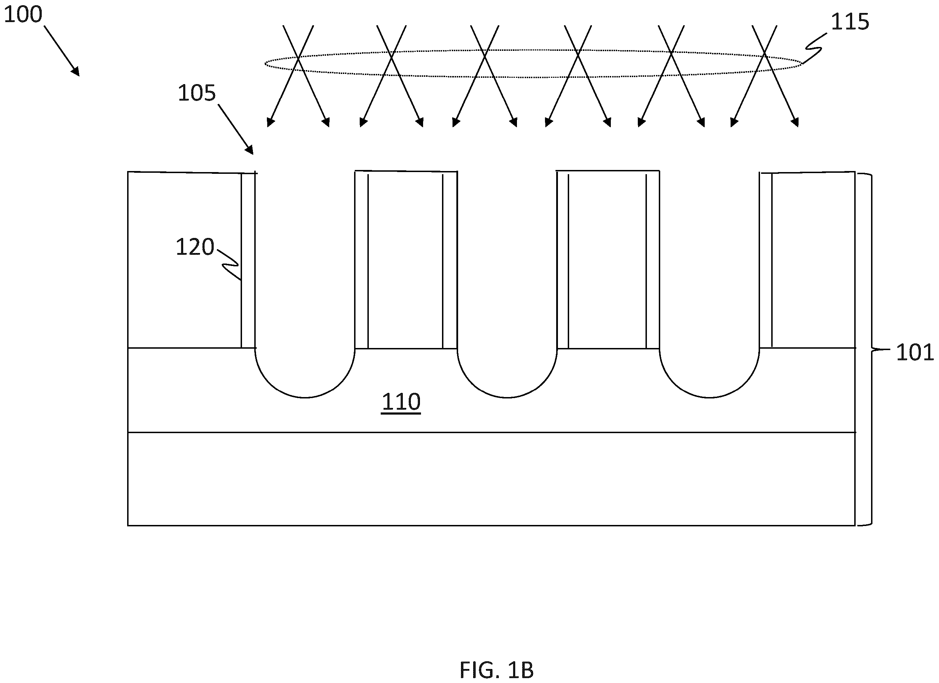

FIG. 1B shows the device 100 during an implant process 115. The implant process 115, which may include more than one, e.g. two, angled implants, provide a suitable dopant to sidewalls of the trenches 105 thereby forming doped sidewall 120. The doped sidewalls 120 may have the second conductivity type thereby providing a continuous, junction-less conductive path from the substrate 101 surface to the buried layer 110. In some examples the dopant is or includes phosphorous (P) or arsenic (As). To provide a relatively high conductivity from the surface to the buried layer 115, the doped sidewalls 120 may be doped with a flux of 1E15 atoms/cm² to 1E16 atoms/cm².

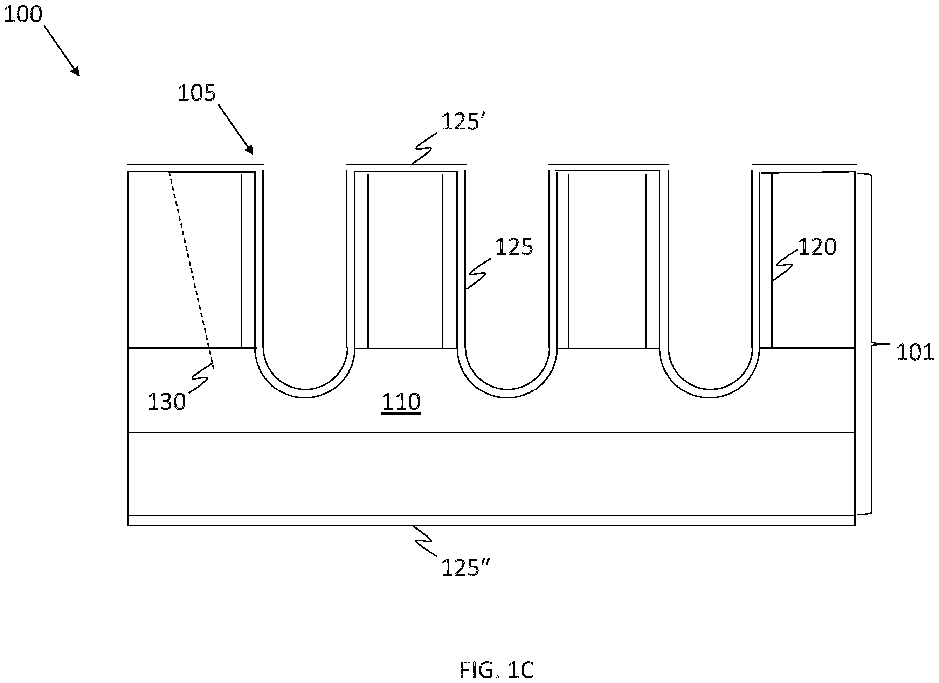

FIG. 1C shows the device 100 after formation of a sidewall oxide liner 125 that may result from some baseline process flows. The sidewall oxide liner 125 may be sacrificial (e.g. removed at a later stage of manufacturing) or persistent. A top-side oxide layer 125' and a bottom-side oxide layer 125" may also be produced coincident with the sidewall oxide liner 125. In some baseline examples, the sidewall oxide liner has a thickness of about 14 nm. The sidewall oxide liner may serve to consume a portion of the substrate 101 surface at sidewalls of the trenches 105 that is damaged or includes impurities related to the etch process (not shown) used to form the trenches 105 and/or the implant process 115. Forming the sidewall oxide liner also serves to anneal lattice damage caused by the implant process 115, thermally activating diffusion processes that incorporate dopants at lattice locations.

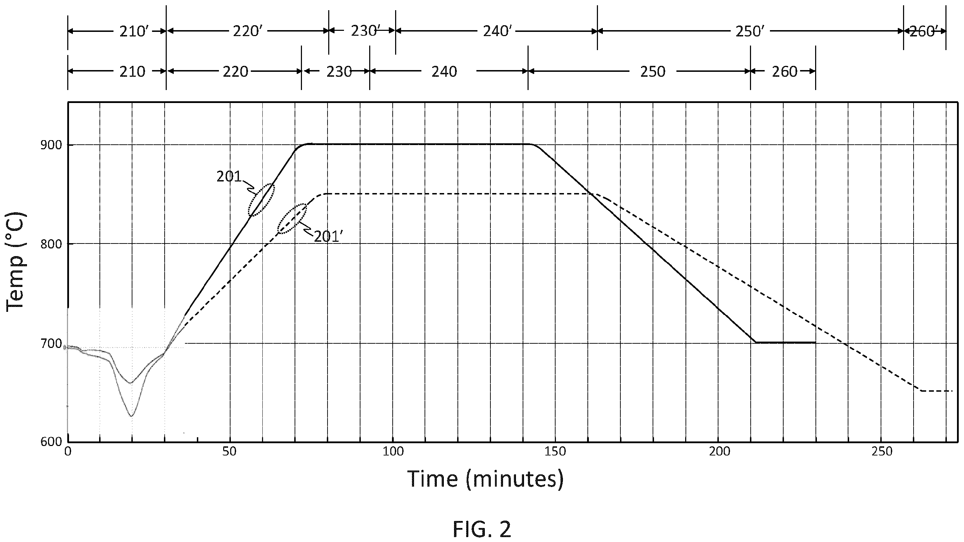

FIG. 2 presents a temperature profile 201 (solid line) of a baseline oxidation process that may be used to form the sidewall oxide liner 125. Typically, one or more semiconductor substrates are introduced to a suitable process tool capable of providing a controlled temperature and an ambient that includes one or more source gasses. A suitable process tool may be a tube furnace, and is described as such in the following discussion without implied limitation. The temperature profile 201 is divided for the purpose of discussion into six process segments, 210, 220, 230, 240, 250 and 260. The process segment 210 includes loading the substrates into the process tool and allowing the tool conditions to stabilize at an initial state. The process tool may have an ambient that is initially stabilized at an initial temperature, e.g. about 700 °C, and a gas flow of 99% N₂/1% O₂. As illustrated, an excursion from the stabilized temperature may result from opening the process chamber and loading the substrates, which are typically retained in a batch carrier, or "boat".

In the illustrated example the temperature drops to about 650 °C and recovers to about 700 °C within about 10 min. The process segment 220 includes a substantially linear increase of temperature of the process chamber, commonly referred to as a temperature ramp. During the process segment 220 a gas flow of about 99% N₂/1% O₂ is maintained, which in some baseline cases is provided by a flow of 15 ℓ/min N₂ + 0.15 ℓ/min O₂. This gas flow may be maintained for the full duration of the temperature ramp, and may result in growth of a few nanometers of silicon oxide on sidewalls of trench. When the temperature reaches a predetermined oxidation temperature, e.g. 900 °C, at the end of the process segment 220, the stabilization process segment 230 begins. The stabilization process segment 230 may have a duration of about 20 min, and allows the multiple substrates in the process boat to reach a uniform temperature. During the stabilization process segment 230 the gas flow in the process chamber may be maintained at about 15 ℓ/min N₂ + 0.15 ℓ/min O₂. After the stabilization process segment 230, an oxidation process segment 240 begins, during which gas flow in the process chamber may be about 25 ℓ/min O₂ with no diluent gases. During this process segment the majority of the sidewall oxide liner 125 may be formed, as compared to other process segments. As illustrated, the oxidation process segment 240 may have a duration of about 50 min in the baseline process. The oxidation process segment 240 may concludes with a stabilization process segment (not explicitly shown), during which the O₂ gas flow is replaced by a gas flow of 25 ℓ/min N₂ for about 5 minutes. After the oxidation process segment 240, and the stabilization process segment if used, the temperature of the substrate is reduced, or "ramped down", to a final unload temperature equal to the load temperature with a gas flow of 100% N₂ at 25 ℓ/min. The substrates, in their carrier, are then unloaded and exposed to ambient fab temperature, e.g. about 20 °C.

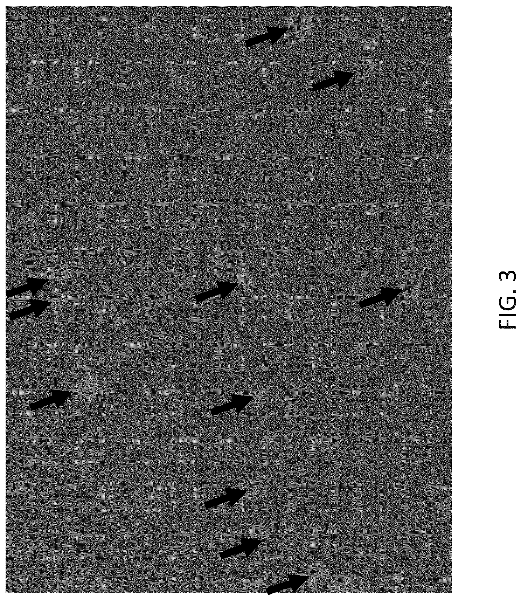

FIG. 3 presents a scanning electron microscope (SEM) image of a portion of a substrate formed according to a baseline process flow such as described by FIGs. 1A-1C and temperature profile 201. The observed square features are dummy moat features. Numerous decorated defects are shown at corresponding arrowheads. These decorated defects represent locations at which lattice dislocations in the silicon substrate intersect the substrate surface. The dislocations are understood to result from accumulated stress in the substrate over the course of the temperature profile 201. Such dislocations are represented symbolically by dislocation line 130 in FIG. 1C. Such defects may result in electrical defectivity in a semiconductor device formed on or in the silicon substrate, e.g. due to leakage along dislocation paths.

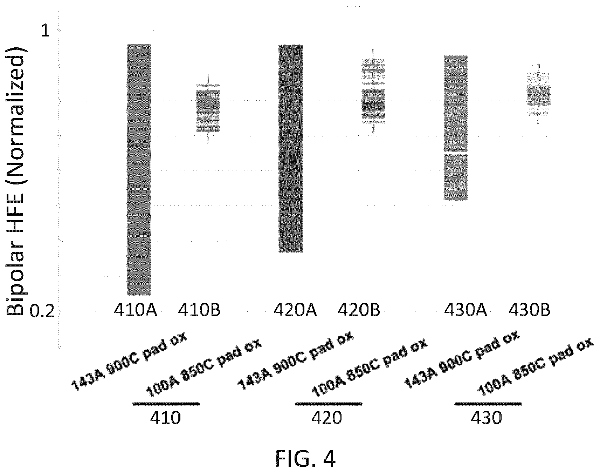

FIG. 4 illustrates an example of such electrical defectivity by way of a chart that includes three pairs of data sets 410, 420, 430 corresponding to h_{fe} (forward current gain) of nominally identical bipolar transistors formed on substrates using three different sidewall implant concentrations between 1E15 atoms/cm² and 1E16 atoms/cm². The substrates used for each data set were all formed with a thickness of about 14 nm for the sidewall oxide liner 125. Data sets 410 have a greater sidewall implant concentration than do data sets 420, which in turn have a greater sidewall implant concentration than do data sets 430. Each pair of data sets includes an "A" data set that corresponds to a baseline process for forming the sidewall liners 125, and a "B" data set that corresponds to an example sidewall oxide formation process of the disclosure, as discussed further below. Thus, data sets 410A, 420A and 430A each correspond to a baseline formation process, and data sets 410B, 420B and 430B each correspond to an example formation process of the disclosure.

The range of each of the data sets 410A, 420A and 430A represents computed standard confidence limits for the discrete measurements within each data set. The data set 410A extends from about 25 to 95 (normalized units), the data set 420A extends from about 35 to 95, and the data set 430A extends from about 50 to 90. This progression is understood to be consistent with decreasing lattice stress progressing from the most-doped example (410A) to the least-doped example (430A). In many cases, even the relatively low spread of the data set 430A may result in excessive yield loss of devices formed on such substrates, and thus an improved process flow is needed.

The inventors have determined that relatively modest changes to the process flow result in a profound and unexpected reduction of lattice dislocation defects as evidenced by h_{fe} measurements. Before describing the improved process flow, attention is directed to data sets 410B, 420B and 430B, which each represent h_{fe} of the representative bipolar transistor at the corresponding implant densities. The ranges of these data sets between standard confidence limits are about 68-88, 70-95 and 72-90 normalized units, respectively, a reduction of about 50-70% as compared to the data sets 410A, 420A and 430A. Moreover, SEM inspection of similar substrate regions as shown in FIG. 3 revealed essentially zero decorated defects at the substrate surface. Without limitation by theory, it is believed that this dramatic improvement results from a combination of reduced stress accumulation in the substrate, especially near and between trenches or other deep openings in the substrate, and reduced thermal shock from the transition from the load temperature to the oxidation temperature, and from the final unload temperature and the fab ambient.

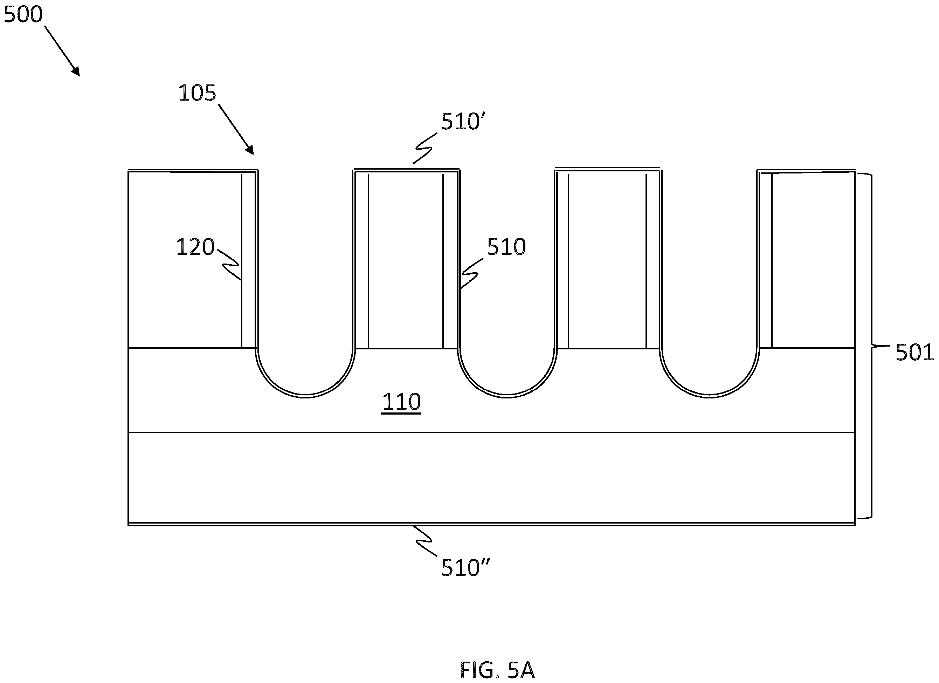

FIGs. 2 and 5A-5C are referred to concurrently in the following discussion. FIG. 2 includes a temperature profile 201' according to an example of the disclosure. FIGs. 5A-5C provide sectional figures that described a substrate 501 at various stages of manufacturing. The temperature profile 201' is divided for the purpose of discussion into six process segments, 210', 220', 230', 240', 250' and 260'. While a sidewall oxide liner formation process according to the temperature profile 201' may be executed in a same or different process tool than a baseline process according to the temperature profile 201, the present discussion assumes the temperature profiles are executed in a same process tool for ease of comparison.

The process segment 210' may include process conditions that are the same or different than those of the process segment 210. In the illustrated example, the process conditions are nominally the same, though as seen some variability of the tube temperature may occur for different process runs. Thus, as described previously the process tool may have an ambient that is initially stabilized at. about 700 °C, and a gas flow of 99% N₂/1% O₂.

The process segment 220' includes a temperature profile that may have a lower ramp rate than the process segment 220. For example, the ramp rate of the process segment 220' may be in a range from about 3.3 °C/min to about 5 °C/min. In the context of temperature ramp, "about" means ±0.5 °C. In some cases a ramp rate of about 3.3 °C/min may produce favorable results. However, whereas the gas flow during the process segment 220 included oxygen, the gas flow during the process segment 220' is substantially oxygen-free, meaning the gas flow does not include added oxygen, with the exception of an initial small amount of oxygen remaining from the wafer load operation during the process segment 210'. For example, a gas flow of 15 ℓ/min N₂ may be maintained during the temperature ramp, with no O₂ or steam. Thus during the temperature ramp little or no oxide is formed on the trench sidewalls. This aspect is thought to be important in reducing substrate stress due to the difference of thermal expansion of silicon and silicon oxide. While preferably no oxide is formed during the process segment 220', it is expected that a non-zero amount of oxide may result from residual oxygen initially in the furnace tube, such that 2-5 nm of oxide may be formed on the trench sidewalls during this process segment. This oxide, if present, is represented by oxide layer 510 (FIG. 5A), as well as layers 510' and 510" on the top and bottom surfaces of the substrate 501, respectively.

When the temperature reaches a predetermined oxidation temperature at the end of the process segment 220', e.g. 850 °C, the stabilization process segment 230' begins. Unless otherwise stated the predetermined oxidation temperature of the stabilization process segment 230' may be in a range from 700 °C to 1000 °C. Optionally, as shown, the predetermined oxidation temperature of the stabilization process segment 230' is lower than the predetermined oxidation temperature of the stabilization process segment 230, in this example by 50 °C, or 850 °C. The lower temperature may be beneficial in some implementations, e.g. to reduce effects of thermal mismatch or temperature differential while stabilizing. As before the stabilization process segment 230' may have a duration of about 20 min. The gas flow in the process chamber during the stabilization process segment 230' may also be about 15 ℓ/min N₂ + 0.15 ℓ/min O₂. After the stabilization process segment 230', the oxidation process segment 240' begins, again during which gas flow in the process chamber may be about 25 ℓ/min O₂ with no diluent gases. Alternatively the gas flow may provide steam (H₂O) at an appropriate concentration to result in similar oxide growth. Either O₂ or steam may be regarded as an "oxidizing ambient". As illustrated, the oxidation process segment 240' may have a duration of about 65 min when the oxidation temperature is 850 °C, reflecting the lower oxide growth rate at the lower temperature than the baseline process. Optionally, the oxidation process 240' ends with a stabilization step during which the gas flow in the process tool may be nonoxidizing, e.g. 25 ℓ/min N₂ for five minutes.

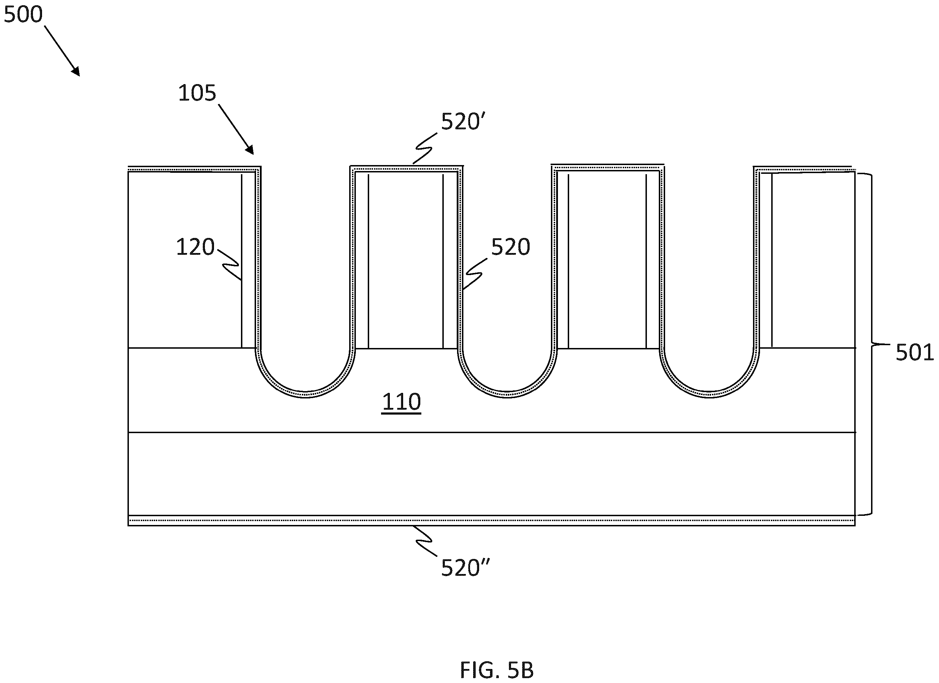

The oxide growth results in formation of an oxide sidewall liner 520 , as well as layers 520' and 520" on the top and bottom surfaces of the substrate 501, respectively, as illustrated in FIG. 5B. A dashed line demarks a transition from the oxide layer 510, if present, to the oxide layer 520. In some examples a target thickness for the oxide sidewall liner 520 is less than the baseline target thickness of 14 nm. In some examples the target thickness of the sidewall oxide layer 520 at the end of the oxidation process segment 240' is about 10 nm. It is thought that in some cases such a lower sidewall oxide thickness may reduce the effects of the thermal transition as the substrate 501 is removed from the process tool.

After the oxidation process segment 240', the temperature of the substrates is ramped down during a cool-down process segment 250' to an unload temperature that may optionally be lower the initial loading temperature. As for the baseline process sequence, the gas flow during the cool-down segment 250' may be 100% N₂ at 20 ℓ/min N₂. In the current example the unload temperature is 50 °C lower than the load temperature, or about 650 °C, but in other examples the unload temperature may be a different value, and/or a different offset from the load temperature. In some examples the rate of temperature reduction may be in a range from -2 °C/min to -3 °C/min. In some examples it may be beneficial to limit the rate of temperature reduction to no greater than -3 °C/min.

Finally, the substrate may be held at the unload temperature for a period of time, e.g. 10-20 min, to allow the one or more substrates to fully equilibrate at the unload temperature before being exposed to fab ambient, e.g. 20 °C.

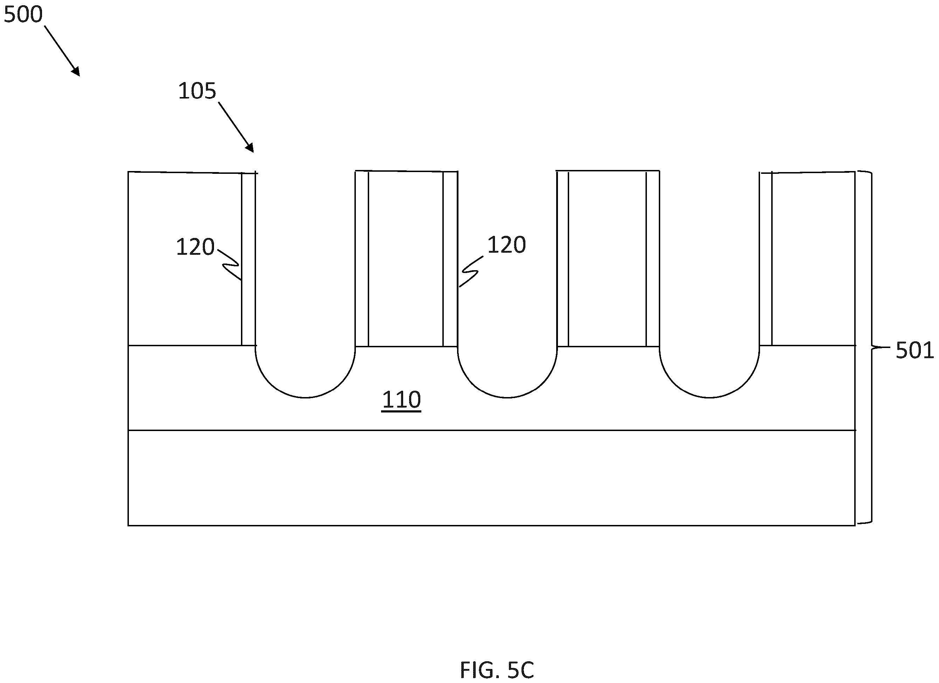

FIG. 5C shows the substrate 501 after optional removal of the oxide layer 520, e.g. by HF strip. The substrate 501, and overlying layers according to the disclosure, may proceed to further processing, such as, for example, filling the trenches with polysilicon, and possibly including forming new oxide sidewall liners.

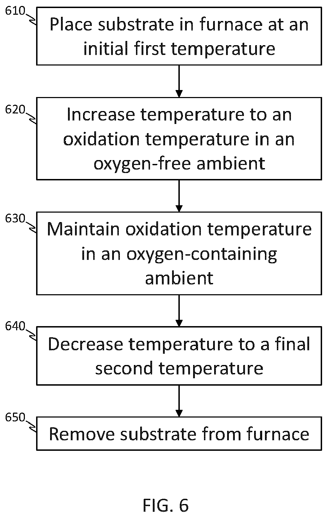

FIG. 6 presents a method 600 that includes various aspects of the described method(s) of forming an integrated circuit. At 610, a semiconductor substrate is placed in a process chamber at an initial first temperature. In various examples trenches are located within the semiconductor substrate. At 620 the temperature of the semiconductor substrate is raised in a substantially oxygen-free ambient to an oxide-growth temperature. In a step 630 the temperature of the semiconductor substrate is maintained at the oxide growth temperature in an oxidizing ambient, thereby forming an oxide layer on surfaces of the substrate, including trench sidewalls if present. In a step 640 the temperature of the semiconductor substrate is reduced to a final temperature below the initial temperature. And at 650 the substrate is removed from the process chamber.

The description provided herein has provided a method or methods of forming an integrated circuit that includes forming an oxide layer on surfaces of a semiconductor substrate including trench sidewalls when present, in a manner that reduces stress within the substrate and thereby substantially reduces or eliminates lattice defects such as dislocations that may lead to electrical leakage and yield loss. Without implied limitation, the effectiveness of the method(s) is thought to result from reduction of thermal transients in the substrate during annealing of the substrate and/or formation of sidewall oxide layers on trenches in the substrate, and/or reduction of thermal shock, e.g. a too-rapid change of temperature of the substrate. It has been discovered that relatively minor changes to a previous baseline process that resulted in numerous dislocation defects result in a surprising and unexpected reduction in such defects . The results of the disclosed methodology clearly show a profound improvement over known baseline process methodologies.

The above discussion is meant to be illustrative of the principles and various embodiments of the present invention. Numerous variations and modifications will become apparent to those skilled in the art once the above disclosure is fully appreciated. It is intended that the following claims be interpreted to embrace all such variations and modifications.

## Claims

1. A method of forming an integrated circuit, comprising:
placing a semiconductor substrate in a process chamber at an initial temperature, the semiconductor substrate having a trench formed therein;
increasing the temperature of the semiconductor substrate in a substantially oxygen-free ambient to an oxide-growth temperature;
maintaining the temperature of the semiconductor substrate at the oxide growth temperature while providing an oxidizing ambient, thereby forming an oxide layer on sidewalls of the trench;
reducing the temperature of the semiconductor wafer to a final temperature below the initial temperature; and
then removing the substrate from the process chamber.

2. The method of Claim 1, wherein the oxide-growth temperature is in a range from 700 °C to 1000°C.

3. The method of any of Claims 1 to 2, wherein increasing the temperature includes increasing the temperature at a rate in a range from 3.°C/min to 5.0 °C/min.

4. The method of any of the preceding Claims, wherein 2 nm to 5 nm of oxide forms on the trench sidewalls before providing the oxidizing ambient.

5. The method of any of the preceding Claims, wherein reducing the temperature includes a) ramping the temperature at a rate in a range from -2 °C/min to -3 °C/min and/or b) limiting the rate of temperature decrease to -3 °C/min.

6. The method of any of the preceding Claims, wherein the final temperature is at least about 50 °C/min lower than the initial temperature.

7. The method of any of the preceding Claims, wherein the trench has depth of at least 1 µm and/or the oxide layer has a final thickness of about 10 nm.

8. The method of any of the preceding Claims, further comprising stripping the oxide layer after removing the substrate from the process chamber.

9. The method of any of the preceding Claims, further comprising implanting an N-type dopant in sidewalls of the trench before placing the semiconductor substrate in the process chamber.

10. The method of any of the preceding claims, wherein the processing chamber is a furnace and the initial temperature is a load temperature and the final temperature is an unload temperature, the method further comprising:
forming a trench in a semiconductor substrate;
increasing the temperature of the semiconductor substrate to the growth temperature while flowing an oxygen-free gas through the furnace.

11. The method of any of the preceding Claims, further comprising reducing the temperature of the semiconductor substrate from the growth temperature to the final or unload temperature at a rate that does not exceed 3 °C/min and/or increasing the temperature includes limiting the rate of temperature increase to 5 °C/min.

12. The method of any of the preceding Claims, wherein increasing the temperature of the semiconductor substrate includes increasing the furnace temperature no more than 150 °C.

13. The method of any of the preceding Claims, wherein the initial or load temperature is about 700 °C and/or the oxide growth temperature is about 850 °C and/or the final or unload temperature is about 650 °C/min or no greater than 650 °C/min.

14. The method of any of the preceding Claims, wherein increasing the temperature includes heating the processing chamber or furnace from 700 °C to 850 °Cover 50 minutes and/or maintaining the temperature includes maintaining the furnace temperature at 850 °C for 80 minutes and/or the unloading or final temperature is 650 °C.

15. The method of any of the preceding Claims, wherein the trench is a component of an isolation structure or is a component of a capacitor.
